Europäisches Patentamt

European Patent Office

Office européen des brevets

(11) Publication number : **0 501 686 A1**

# (12) EUROPEAN PATENT APPLICATION

(21) Application number : 92301438.5

(51) Int. Cl.<sup>5</sup> : **H01L 21/205, C30B 25/02**

(22) Date of filing : 21.02.92

(30) Priority : 28.02.91 US 662549

(43) Date of publication of application :
02.09.92 Bulletin 92/36

(84) Designated Contracting States :
BE DE FR GB NL

(71) Applicant : **AMERICAN TELEPHONE AND TELEGRAPH COMPANY**
**550 Madison Avenue**
**New York, NY 10022 (US)**

(72) Inventor : **Abernathy, Cammy Renée**
**294 Country Club Lane**
**Scotch Plains, New Jersey 07076 (US)**

Inventor : **Hobson, William Scott**
**51 Karen Way**
**Summit, New Jersey 07901 (US)**
Inventor : **Jordan, Andrew Stephen**
**428 White Oak Ridge**
**Short Hills, New Jersey 07078 (US)**
Inventor : **Pearton, Stephen John**
**19 Euclid Avenue - Apt. 3**
**Summit, New Jersey 07901 (US)**
Inventor : **Ren, Fan**
**13 Berkshire Drive**
**Warren, New Jersey 07059 (US)**

(74) Representative : **Watts, Christopher Malcolm Kelway, Dr. et al**
**AT&T (UK) LTD. AT&T Intellectual Property Division 5 Mornington Road**
**Woodford Green Essex IG8 OTU (GB)**

(54) Fabrication of aluminium-containing semiconductor devices by metal-organic molecular-beam-epitaxy.

(57) Process for introduction of aluminum during MetalOrganic Molecular Beam Epitaxy are dependent upon specification of source materials for yielding the aluminum. A major obstacle to use of this excellent growth process, particularly as applied to a major class of compound semiconductor devices, is overcome by using a precursor compound of the class of trimethylaminealane (TMAAl). Expeditious growth of high quality materials within the direct bandgap AlGaAs composition range has broad implications as concerning LSI/VLSI integrated circuits-electronic, photonic, as well as hybrid.

EP 0 501 686 A1

## Background of the Invention

### 1. Technical Field

The invention relates to compound semiconductor-based devices of the category including one or more aluminum-containing regions, e.g. AlGaAs, AlAs, AlInAs, AlInP. Primary use is in integrated circuits with function dependent upon electronic, photonic or hybrid properties. Significant circuit categories include heterojunction bipolar transistors and/or photonic devices, e.g. lasers and detectors.

### 2. Description of the Prior Art

It has been decades since the first confident prediction that silicon would yield to compound semiconductors, III-Vs, II-VIs, as well as ternaries and quaternaries. Failure to replace silicon is to large extent based on a now-familiar economic pattern. Desired avoidance of the significant cost entailed in equipment design/replacement and in retraining of workers justifies ongoing worldwide efforts to yield ever-improving devices with realization of properties previously thought unobtainable with silicon. With respect to most prevalent LSI/VLSI structures, as exemplified by e.g. megabit and larger capacity chips, it is anticipated that silicon will continue to be dominant.

Fundamental properties of certain of the compound semiconductors, however, suggest substitution for silicon in specialized device classes. Aluminum is a favored inclusion in one or more regions of such devices. As partially substituted, e.g. for host atoms in the group III site, it increases bandgap to result in increased power capability as well as in desired photonic properties.

A class of photonic devices receiving worldwide attention is the GaAs-based Surface Emitting Laser which offers promise of high density optical integrated circuits - a promise of many years' standing, now likely to be fulfilled due to minimization of heat generation accompanying low lasing threshold.

## Summary of the Invention

A class of precursor aluminum-yielding compounds facilitates MetalOrganic Molecular Beam Epitaxial (MOMBE) fabrication of a large category of devices, importantly integrated circuits, both LSI and VLSI. Such precursor compounds, illustrated by trimethylamine alane (TMAAl), avoid unintended carbon-doping (p-type doping) of particular consequence in the production of intrinsic conductivity as well as of n-type regions. Exposure to oxygen does not yield volatile Al-O species, and thereby avoids transport of oxygen to the growth surface. Oxygen incorporation, characteristics of earlier sources, serves as a deep acceptor - in turn as a recombination center - impairing both electronic and photonic devices. (In the former, such centers limit current how and, consequently, gain; in the latter they behave as non-radiative recombination centers, e.g., to increase lasing threshold).

Filling the need for a robust, versatile aluminum-yielding source for use in MOMBE overcomes the primary reason for unavailability of this most desirable epitaxial growth technique for general use with aluminum-containing materials. In so doing, it overcomes limitations of MetalOrganic Chemical Vapor Deposition (MOCVD) and Molecular Beam Epitaxy (MBE). MOCVD does not offer precision and thickness uniformity - of increasing importance for large wafers. MBE's limitations include inability to grow reproducible phosphorus-containing films as well as p-type layers of desired free carrier concentration.

The inventive approach is usefully employed in the fabrication of devices entailing use of tin-yielding (n-doping) precursor material in accordance with our concurrently filed European patent application claiming priority from USA application No. 662,550. It is useful, too, with regard to p-doping based on carbon introduction during MOMBE growth as described in *App. Phys. Lett.* Vol. 55, No. 17, pp. 1750-21 (23 Oct. 1989).

## Brief Description of the Drawing

FIG. 1 is a schematic view of an electronic device illustrating a device class of particular relevance in terms of the invention.

FIG. 2 is a schematic view of a surface emitting laser device, representing a broad class of photonic devices benefitting from the inventive teaching.

FIG.3 on coordinates of concentration on the ordinate and depth on the abscissa is referred to in a discussion of relationship as between these two parameters in a finally fabricated junction, with values as yielded by "secondary ion mass spectroscopy" (SIMS) during sputter-removal of the GaAs-based material.

FIG. 4 on coordinates of intensity and energy compares luminescense efficiency of AlGaAs as grown by MOMBE in accordance with the invention as compared with an exemplary prior art and MOCVD process.

**Detailed Description**

General

The basic thrust of the invention is provision of a class of aluminum-yielding precursor compositions suitable for use with MOMBE - thereby avoiding limitations imposed by MBE and MOCVD. MBE is regarded as limited in its ability to grow highly doped p-type compound semiconductor as well as phosphorus-containing films in a reproducible manner due to the allotropic nature of phosphorus. (The different phosphorus structures, with their attendant variation in volatility, cause difficulty in flux control.) Advantage over MOCVD involves layer thickness control to permit high-yield production of large wafers - wafers larger than two inches in lateral dimension. These compositions meet fundamental needs for expedient processing e.g. sufficient volatility at convenient temperature. As compared with earlier sources, preliminary indications suggest lowered growth temperature for device quality material (examples in this description used 500°C).

Most importantly, source compositions of the invention avoid the oxygen and carbon contamination which characterized previously investigated metalorganic aluminum sources, e.g. triethylaluminum (TEAl).

Source compositions are generally defined as coordinatively saturated and having vapor pressures sufficient for expeditious growth - the material used in the examples has a vapor pressure of $\approx 1.0$ Torr at 20°C. Chemically, the class of compositions is represented as:

$$R_3M \cdot AlH_3$$

in which:

R groupings, not necessarily identical, are hydrocarbon substituents so chosen as to result in a vapor pressure for the source compound which is appropriate to growth. In general, a vapor pressure of 0.01 Torr, measured at 298 K, has been sufficient for vapor introduction to the growing interface. For compounds in which R groupings are identical, methyl, ethyl and propyl are usefully employed "M", in the examples, nitrogen, is chosen to realize the stability and volatility to result in removal of $R_3M$ upon dissociation of the adduct at the growth surface. Other elements may serve but are generally somewhat more restricted in use. For example, phosphorus generally meets the requirements served by nitrogen, but, unlike nitrogen, extremely small inclusion in the growing material affects device properties.

For the most part, results here reported made use of simple unsubstituted trialkylamine alane, primarily trimethylamine alane (TMAAl). Higher order homologs, e.g. TEAAl, may be used depending on acceptability of lowered growth rate. Other variations, such as more complex precursors containing dissimilar R groupings, may be used but generally offer no advantage.

Resulting Composition

Intense activity in compound semiconductors has concerned GaAs-based devices containing one or more aluminum-containing regions. While not so limited, device-relevant aluminum content is at this time at a minimum of 1 at% as based on total group III site occupancy. Larger aluminum content increases the magnitude of associated properties. These include gain in electronic devices as well as confinement of carriers in optical devices. Optimum advantage for these and other purposes, at least in the instance of GaAs based material, is in the 15-35 at.% range. For many purposes an ultimate limit is at the crossover between direct and indirect bandgap - in otherwise unsubstituted GaAs, at $\approx 45$ at% (always as based on total group III site occupancy).

In facilitating growth of aluminum-containing compound semiconductor material, the invention addresses GaAs-based devices as well as devices based on a variety of other compound semiconductors. This extension of MOMBE increases freedom of choice for lattice matched materials - e.g. in terms of paired materials, AllnAs-InP and AlGaAs-GaAs. It is likely that first significant implementation of the invention will involve growth of a variety of AlGaAs compositions on a GaAs substrate. This category of devices generally makes use of grown layered material which is pseudomorphic with the binary compound, GaAs. Emphasis on such materials, while largely owing to acknowledged device properties, is in part owing to the advanced state of development of GaAs relative to other III-V's.

Most significant contemplated device categories involve epitaxial layer growth. Relevant materials are those having lattice constants to permit growth of device-functional crystalline perfection. This consideration must take a number of factors into account. For example, requisite perfection, which in any event depends upon intended device function, varies with layer thickness - greater mismatch with grown material is permitted for thin growing material.

Compositional variation in such GaAs-based devices is often dictated by retention of suitable characteristics - particularly direct bandgap. Contemplated materials generally contain at least 45 at.% gallium, in many instances at least 60 at.% in the III site, as further limited by lattice considerations discussed. Aluminum is, at this time, the most significant added element. AlGaAs composition are of larger bandgap than that of the binary composition, with the gap increasing in magnitude but going from direct to indirect with increasing aluminum (with the crossover for otherwise substituted AlGaAs compositions, at about 45 at.% unsubstituted Ga). Indium, the second most probable substitution, itself forms a direct bandgap composition when combined with arsenic, so that its inclusion may permit larger gallium substitution - e.g. leaving less than $\approx$ 45% retained gallium.

Consistent with lattice and composition limitations set forth, other substitutions - either in aluminum-containing or in non-aluminum-containing regions - may serve device needs. Indium is a prominent candidate, with amounts of 5-20 at.% (as above, based on total site III occupation) resulting in higher carrier mobility as well as decreased bandgap. The resulting gap value is in the range of from 1.37 to 1.2 ev. Indium substitution is illustrative of likely compromise with a view to device operation. An advantage of GaAs-based devices is the high power capability due to increased bandgap. Specification of such compositions should be with a view to the relative importance to be placed on device properties dependent on carrier mobility and power.

## Processing Considerations

Objectives of the invention are critically dependent upon introduction of aluminum by MOMBE (considered by some as overlapping or alternatively denoted "Gas Source Molecular Beam Epitaxy" or "Chemical Beam Epitaxy"). Device operating characteristics and flexibility of design require at least one region meeting this requirement. The process requirements of MOMBE are well-known, see for example, G. J. Davies, et al. Chemtronics $\underline{3}$ (1988) 3. In general, it is expected that MOMBE will serve needs for introduction of other elements into such region as well. Appropriate MOMBE sources for many host and dopant elements are now available. Use of multiple source chambers, however, permit simultaneous use of other processes, e.g. MBE, where desired. It is also contemplated that the complete device may entail regions, perhaps of non-aluminum-containing compositions to be effectively satisfied by sequential use of alternative processes

While detailed information is to be derived from references, it is useful to briefly outline the nature of MOMBE. MOMBE combines the gaseous sources of MOCVD with the UHV growth environment of MBE. This combination produces a molecular beam of gaseous molecules which decompose on the heated GaAs substrate surface. In order to maintain molecular flow in the growth chamber, the total pressure in the chamber is maintained at levels < $10^{-3}$ Torr. While MBE, by common definition, uses only elemental sources for the Group III, Group V, and dopant elements, MOMBE can utilize any combination of elemental and gaseous sources, provided that at least one or more of the Group III or dopant elements are supplied via the use of a gaseous source.

## Devices/Circuits

Primary value of the invention is realized in present and future state-of-the-art structures - importantly, integrated circuits, at this time built to design rules of $\approx$ 2 $\mu$m; in the future likely to be of reduced scale - 1 $\mu$m or submicron, perhaps to one or a few tenths of a micron. Pronounced advantages of the inventive approach are of increasing importance as applied to such structures in that they include increased speed (a driving force toward reduced scale) as well as the increased power (as associated with the increased bandgap of AlGaAs - a parameter of particular consequence with increased miniaturization).

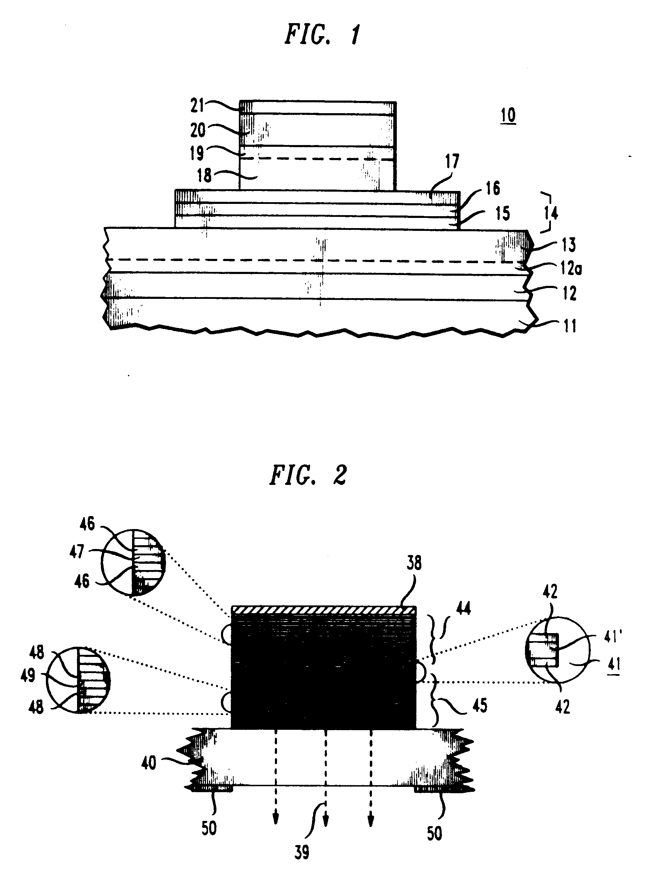

Description of FIG. 1 is first in generalized terms, and thereafter in terms of two Examples - the first descriptive of a Pnp. (Consistent with general usage the "P" refers to a region of broad band relative to the narrow band suggested by the use of the lower case "p". Also consistent with such use, the designation, e.g. Pnp does not specify position, so that the "P" may be initially or finally grown.) The second example refers to the complementary structure - to the Npn. As described above, invention-permitted Pnp designs result in gain advantage which flows from the inventive ability to reliably produce Al-containing material (e.g. $Al_xGA_{(1-x)}As$) of lowered contamination - particularly of lowered oxygen content. In terms of the complimentary structure, the Npn advantage is largely in terms of the n-type emitter, including avoidance of uncontrolled compensation by carbon as well as avoidance of oxygen trapping resulting in increased gain. Increasing gain, in turn increases $f_{max}$ (the figure of merit of device frequency as affected by gain - the extrapolation of the maximum available gain v. frequency curve to 0 gain).

FIG. 1 is used in description of the "emitter-up" as well as the inverted structure, the "collector-up" device. Description is initially in terms of the former. The device 10 depicted in FIG. 1 consists of substrate 11 supporting successively grown layers 12, serving as sub-collector, collector 13 and base region 14, in turn consisting of layers 15, 16 and 17. It is convenient to describe layer 16 as the functional base layer with embracing layers 15 and 17 (generally compositionally graded) serving as spacer regions (some writers refer to the entirety of region 14 as the base region). Aluminum-containing emitter layer 18 is followed by optional layer 19 and finally by layers 20 and 21, the three constituting the emitter contact region in usual nomenclature.

The collector-up device in similar terms consists of substrate 11 followed by emitter contact 12, optional emitter contact layer 12a (layer 12a, if included, is compositionally/conductively graded), aluminum-containing emitter layer 13, base layer 14 in turn consisting of the functioning base layer 16 sandwiched between spacer/graded layers 15 and 17 followed by collector layer 18 and finally by the collector contact region made up of layers 20 and 21. The optional graded layer 12a, serving the function of graded layer 19 in the emitter-up structure is useful as between embracing layers to assure a smooth transition as between a layer 12 of unsubstituted GaAs composition and the AlGaAs layer 13.

Description of this figure is largely in terms of device-function advantage uniquely gained by use of inventive processing - advantage importantly in terms of gain. While certainly of consequence with attention to specific device elements, there is far greater consequence in terms of realizable advantage in terms of circuitry, e.g. integrated circuits, entailing other devices. A graphic example entails the HBT npn structure previously described by the inventors (see vol. 55, no. 17, App. Phys. Let., pp. 1750-2 (Oct. 23, 1989)). This earlier reported work concerns device advantages for p-base Npn structures which derive from facility for increased and controlled p-type doping level, again from gaseous source material, e.g. trimethylgallium, in the course of MOMBE growth. As significant as this earlier work is, the overall value as multiplied by combination with complementary devices in accordance with the invention. Operation of circuits, importantly Integrated Circuits, containing both Npn's and Pnp's of improved response time is properly described as synergistic.

Such HBT IC's are expected to receive early commercial attention. There are, in addition, established functions which are satisfied by inclusion of unipolar device elements (MOS, MESFET, HEMT). Aside from gains realizable in terms of such elements themselves (based on device-operation, or simply on fabrication convenience), further operational advantages are again realized in IC's containing two or more types of elements.

It has been noted that the inventive approach is of particular interest in terms of photonic devices, e.g. lasers, detectors, etc. Many contemplated compound semiconductor lasers make use of aluminum-containing regions which are vulnerable to the deficiencies addressed by the invention. In particular deep level traps as introduced during aluminum incorporation by relevant prior art processes - e.g. by use of triethylaluminum (TEAl) - act as nonradiative recombination centers. Consequent increase in treshold of affected laser structures aggravates the heat dissipation problem. In view of most, failure of the laser to find its way into high density integrated circuits over the many years since its first successful operation is due to precisely this problem. Problems of consequence in electronic devices are retained as well in photonic devices - incorporation of oxygen results in unwanted carrier recombination to reduce gain, as well as unintended introduction of elemental carbon to complicate dopant control. Of course both are alleviated by MOMBE introduction by aluminum using the invention-designated sources.

Widespread effort is being directed to the Surface Emitting Laser. This structure shows promise of overcoming the obstacles to high density integration. Advantages realized by the invention are of particular consequence to the SEL. SEL's as reported in the literature are a variety of forms. Reference is made for example to J. L. Jewell, et al. Optical Engineering, Vol. 29, pp. 210-214, March 1990, as well as references cited in that paper. Many of the advantages of aluminum-containing material - many of the advantages of the present invention - are retained in other laser structures. These include other thin film structures, such as edge emitters (e.g. in the favored form of the stripe laser). Description of a variety of lasers is included in standard texts e.g. in A. Yariv's Quantum Electronics, pub. Wiley, New York, (1989). The description of FIG. 2 does not include detailed discussion of structural requirements, which in any event are well known, but instead stresses aspect of particular relevance to the inventive teaching. The structure consists of a face electrode 38 of sufficient reflectivity to result in emission in the form of a downwar-directed beam 39 shown in the form of arrows emerging from the underside of substrate 40 (the substrate upon which the laser structure is grown). Functionally the depicted element depends upon active region 41, which, in one popular version, consists of one or more quantum wells 41 embraced by barrier layers 42. The composition of the material of which the wells are composed (or, alternately, of which a substituted bulk active material is composed) depends upon desired emission wavelength. As an example, AlGaAs compositions are useful at 780 and 630 nm. Embracing barrier material also contains aluminum in the instance of GaAs-based devices. Functioning of such barrier layers - both as defining the quantum well and for confining free carriers within the well - depends upon increased bandwidth (relative to that of the well). This, in turn, is achieved by relatively large aluminum concentration - likely at the $\simeq$ 20 at% level.

Mirrors 44 and 45, both Distributed Bragg Reflectors, depend upon large layer-to-layer differential refractive index - again readily achieved in aluminum-containing layered material. DBR's 44 and 45, one p-type, the other n-type, are made up respectively of quarter wavelength paired layers 46-47 and 48-49 respectively. One operating structure is described in U.S. Application SN 317,699 filed 3/1/89, which is hereby incorporated by reference. DBR mirrors were made up of alternating layers of AlAs and GaAs. (For a structure there described, pair-reflectance of 99.4% translated into $\simeq$ 22 pairs/mirror for the desired cavity reflectance of 99.9%. Structural details such as the use of graded compositions in the p-type mirror, and of superlattices, are described in the literature and are not considered appropriate to this description.

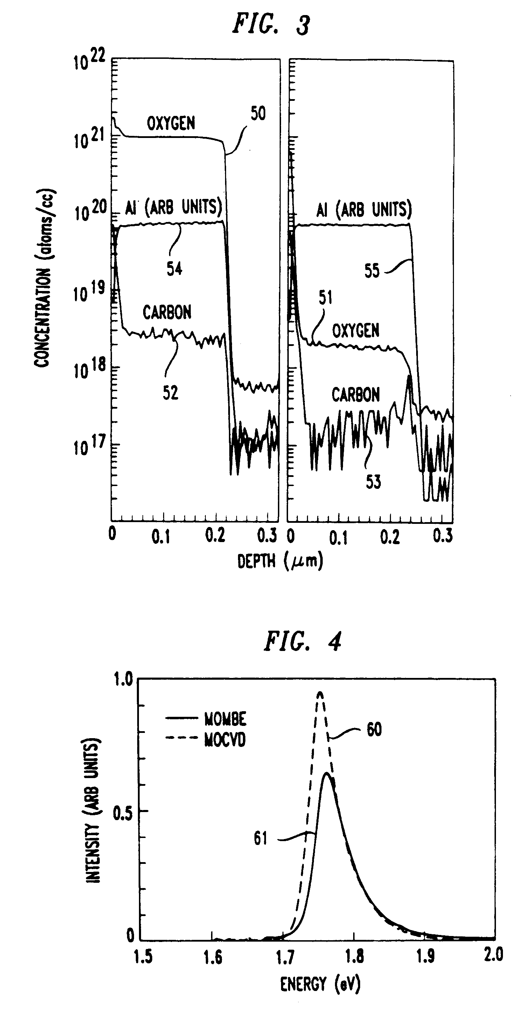

FIG. 3 on coordinates of concentration in atoms/cubic centimeter on the ordinate and depth in $\mu$m on the abscissa presents data which compares the inventive approach with relevant prior art. Data presented is that of SIMS analysis of the composition $Al_{0.53}Ga_{0.47}As$ - on the left side of the plot (curves 50, 52, 54 for oxygen, carbon, aluminum respectively) as grown from TEAl by MOMBE; on the right side (curves 51, 53, 55 for the same elements in the same order) as grown from TMAAl by MOMBE. The analytical process, Secondary Ion Mass Spectrometry (SIMS) is described for example in R. G. Wilson, F. A. Stevie and C. W. Magee, SIMS:A Practical Handbook for Depth Profiling and Bulk Impurity Analysis, Wiley (1989). Oxygen content, source of deep level traps, is reduced by an amount approaching 3 orders of magnitude (from $\approx 10^{21}$ atoms/cc to $\approx$ 2-$3\times10^{18}$). Content of carbon, a prominent p-type dopant for GaAs-based semiconductors, was reduced about an order of magnitude. For comparison purposes, aluminum-content, presented in arbitrary units on curves 54, 55, was at the same level - at 0.57 $\pm$ at.% occupancy of the group III site - for both compositions analyzed.

Layered material of device-useful luminescence has been grown by MOCVD from TMAl. Use of the same source material has not resulted in luminescence for MOMBE growth. The data presented in FIG 4 is believed to represent the best MOMBE-grown luminescent material. PL spectra presented on coordinates of intensity (in arbitrary units) on the ordinate and photon energy (in electron volts on the abscissa) show device-useful luminescence thus far obtained, both for $Al_{0.23}Ga_{0.77}As$ as grown by MOCVD (broken curve 60) and as grown by MOMBE from TMAAl (solid curve 61). (While peak intensity is somewhat reduced, the MOMBE-yielded luminescence is sufficient for device use). A further advantage of the inventive process is in terms of low temperature growth capability - MOMBE data presented is for 500° C at the growing surface, while that for MOCVD was 675° C.

## Examples

### Example 1

Reference is made to FIG. 1 in defiled description of conditions used in the fabrication of a emitter-up Pnp device. Much of the data is set forth in the form of a table (number designations in column 1 correspond with the reference numbers in the figure):

Pnp: Growth Temperature = 500°C

| Layer (Time:Thickness) | Composition | Source | Source Temp (°C) | Carrier Gas Flow Rate (SCCM) | Bubbler Pressure (Torr) |
|---|---|---|---|---|---|
| 20 Emitter Contact (441 sec:2000 Å) | GaAs:C | TMG<br>As H$_3$ | -9.4<br>- | 5<br>5 | 60<br>- |
| 19 Graded Layer (70 sec:200 Å) | Al$_x$Ga$_{1-x}$As:C | TMG<br>TMAAl<br>AsH$_3$ | -9.4<br>9.2<br>- | 0.7 to 5<br>10 to 0<br>25 to 5 | 60 to 70<br>6 to 1.5<br>- |
| 18 Emitter (400 sec:800 Å) | Al$_{.35}$Ga$_{.65}$As:C | TMG<br>TMAAl<br>AsH$_3$ | -9.4<br>9.2<br>- | 0.7<br>10<br>25 | 70<br>6<br>- |
| 17 Base (109 sec:100 Å) | Al$_{.35}$Ga$_{.65}$As | TEG<br>TMAAl<br>AsH$_3$ | 11.9<br>9.2<br>- | 1.1<br>10<br>5 | 6<br>6<br>- |
| 16 Base (13 sec:35 Å) | GaAs | TEG<br>AsH$_3$ | 11.9<br>- | 4<br>10 | 6<br>- |
| 15 Base (150 sec:700 Å) | GaAs:Sn | TEG<br>TESn<br>AsH$_3$ | 11.9<br>-6.7<br>- | 4<br>7<br>10 | 6<br>6<br>- |
| 13 Collector (2000 sec:4000 Å) | GaAs:C | TEG<br>TMG<br>AsH$_3$ | 11.9<br>-9.4<br>- | 1.1<br>0.7<br>25 | 6<br>70<br>- |
| 12 Sub-collector (882 sec:4000 Å) | GaAs:C | TMG<br>AsH$_3$ | -9.4<br>- | 5<br>5 | 60<br>- |

Carrier concentration in base region 15, in this instance essentially constant, was about $1.5 \times 10^{19}$ cm$^{-3}$.

Example 2

The device fabricated in accordance with this example, again of the configuration shown as FIG. 1 was of emitter-up Npn configuration and, accordingly, was constituted of the layers identified in discussion of that variation. Fabrication data is again set forth in tabular form.

Npn: Growth Temperature = 500°C

| Layer (Time:Thickness) | Composition | Source | Source Temp (°C) | Carrier Gas Flow Rate (SCCM) | Bubbler Pressure (Torr) |
|---|---|---|---|---|---|
| 21 Emitter Contact (80 sec:300 Å) | $In_x Ga_{1-x} As:Sn$ | TMI TEG | 15 11.9 | 0.8 to 8.0 4.0 to 0.4 | 4.2 6 |
| | | TESn AsH$_3$ | -6.8 - | 6.0 to 13.1 10 | 6 - |
| 20 Emitter Cap (533 sec:2000 Å) | GaAs:Sn | TEG | 11.9 | 4.0 | 6 |
| | | TESn AsH$_3$ | -6.8 - | 6 10 | 6 - |
| 19 Emitter Graded Layer (60 sec:200 Å) | $Al_x Ga_{1-x} As:Sn$ | TEG TMAAl | 11.9 9.2 | 2.4 to 4 10 to 1 | 6 7 |
| | | AsH$_3$ TESn | - 6.8 | 7.5 to 10 3.4 to 6 | - 6 |
| 18 Emitter (240 sec:800 Å) | $Al_{.3} Ga_{.7} As:Sn$ | TEG | 11.9 | 2.4 | 6 |
| | | TMAAl TESn AsH$_3$ | 9.2 -6.8 - | 10 3.4 7.5 | 7 6 - |
| 14 Base (200 sec:700 Å) | GaAs:C | TMG | -9.4 | 4 | 60 |
| | | AsH$_3$ | - | 5.5 | - |
| 13 Collector (1333 sec:5000 Å) | GaAs:Sn | TEG | 11.9 | 4 | 6 |
| | | TESn AsH$_3$ | -6.8 - | 0.3 10 | 95 - |
| 12 Sub-collector (1333 sec:5000 Å) | GaAs:Sn | TEG | 11.9 | 4 | 6 |
| | | TESn AsH$_3$ | -6.8 - | 15 10 | 95 - |

Example 3

   Experimental evidence set forth in this example served as basis for FIG. 3. As noted, this and other experimental information is representative of advantage gained through lessening of oxygen and carbon incorporation. Data is set forth in tabular form of the general format of the preceding examples.

EP 0 501 686 A1

Growth Temperature = 500°C

Sample 1 = 20 min.

| Layer Composition | Source | Source Temp (°C) | Carrier Gas Flow Rate (SCCM) | Bubbler Pressure (Torr) |
|---|---|---|---|---|
| $Al_{.59}Ga_{.41}As$ | TEG | 11.9 | 0.7 | 6.0 |
| | TEA | 51.8 | 20.0 | 10.0 |
| | $AsH_3$ | - | 5 | - |

Sample 2 = 30 min.

| Layer Composition | Source | Source Temp (°C) | Carrier Gas Flow Rate (SCCM) | Bubbler Pressure (Torr) |
|---|---|---|---|---|
| $Al_{.57}Ga_{.43}As$ | TEG | 11.9 | 0.7 | 6.0 |
| | TMAAl | 5.3 | 20.0 | 11.8 |
| | $AsH_3$ | - | 5 | - |

Example 4

The table here set forth represents salient conditions responsible for FIG. 4.

Growth Temperature = 500°C

Time = 1 hr.

| Layer Composition | Source | Source Temp (°C) | Carrier Gas Flow Rate (SCCM) | Bubbler Pressure (Torr) |
|---|---|---|---|---|
| $Al_{.23}Ga_{.77}As$ | TEG | 11.9 | 1.6 | 6.0 |
| | TMAAl | 5.3 | 20.0 | 10.2 |
| | $AsH_3$ | - | 5 | - |

Claims

1. Fabrication of apparatus comprising at least one semiconductor device including an aluminum-containing crystalline region of composition consisting essentially of compound semiconductor, said region being grown epitaxially on a substrate, at least the surface of which is composed of substrate material,
CHARACTERIZED in that aluminum is introduced primarily during MetalOrganic Molecular Beam Epitaxy (MOMBE), in that such aluminum is introduced simultaneously with other ingredients of such region during epitaxial growth to the extent that aluminum together with such simultaneously introduced ingredients constitute at least 99 at.% of said composition, and in that such aluminum is yielded primarily from at least one source of the class: $R_3M \cdot AlH_3$ in which source, R groupings, not necessarily identical, are hydrocarbon substituents so chosen as to result in a vapor pressure appropriate to such growth, and in which M is such as to result in an $R_3M$ substituent of properties permitting dissociation from the said source, thereby resulting in evaporation-removal of such substituent without substantial decomposition, such dissociation occurring under the influence of the growing surface.

2. Fabrication of claim 1 in which said region consists essentially of group III-V compound material, in which M consists essentially of nitrogen, and in that introduced aluminum is at a level of at least 1 at.% in the said region as based on total group III atom occupancy at least at a position within such region.

9

3. Fabrication of claim 2 in which R includes at least one grouping selected from the radicals consisting of $CH_3$ and $C_2H_5$.

4. Fabrication of claim 3 in which such R groupings are chemically identical.

5. Fabrication of claim 4 in which other ingredients of such region are introduced primarily by gaseous sources.

6. Fabrication of claim 5 in which the substrate surface consists essentially of a GaAs-based or an InP-based composition.

7. Fabrication of claim 6 in which the region is GaAs-based, and in which the said introduced aluminum is within the range of from 15 at.% of the total atom occupation of the group III site to a maximum permitting prevalent direct bandgap activity of said region.

8. Fabrication of claim 7 in which introduced aluminum is within the range of from 20 at.% to 35 at.%.

9. Fabrication of claim 1 in which such region is essentially of intrinsic conductivity.

10. Fabrication of claim 9 in which such region is of p-type or n-type conductivity.

11. Fabrication of claim 10 in which such region is GaAs-based and of p-type conductivity, and in which p-type conductivity is essentially due to introduction of elemental carbon by MOMBE from a source consisting essentially of trialkyl gallium.

12. Fabrication of claim 10 in which such region is GaAs-based and of n-type conductivity.

## FIG. 1

## FIG. 2

## FIG. 3

## FIG. 4

EP 0 501 686 A1

**European Patent Office**

# EUROPEAN SEARCH REPORT

Application Number

EP 92 30 1438

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PROC. 17TH INT. SYMP. GALLIUM ARSENIDE AND RELATED COMPOUNDS, 24-27 SEPTEMBER 1990, JERSEY, CHANNEL ISLANDS pages 149 - 153; C.R. ABERNATHY ET AL.: 'Trimethylamine alane: A new robust precursor for MOMBE growth of AlGaAs' * the whole document * | 1-12 | H01L21/205 C30B25/02 |
| X | JOURNAL OF CRYSTAL GROWTH. vol. 105, no. 1/4, 1 October 1990, AMSTERDAM NL pages 1 - 29; W.T.TSANG: 'Progress in chemical beam epitaxy' * Section 7; Reference 72 * | 1 | |
| P,X | IEEE ELECTRON DEVICE LETTERS. vol. 12, no. 6, June 1991, NEW YORK US pages 287 - 289; T.H.CHIU ET AL.: 'Growth and metallization of AlGaAs/GaAs carbon-doped HBT's using trimethylamine alane by CBE' * the whole document * | 1-12 | |

TECHNICAL FIELDS SEARCHED (Int. Cl.5)

H01L
C30B

The present search report has been drawn up for all claims

| Place of search | Date of completion of the search | Examiner |
|---|---|---|
| BERLIN | 04 JUNE 1992 | MUNNIX S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

13